# EUROPEAN PATENT APPLICATION

(11) **EP 1 191 832 A2**
(43) Date of publication of application: **27.03.2002**
(21) Application number: 01116540.4
(22) Date of filing: 09.07.2001
(51) Int. Cl.: H05K 13/04

(54) **Automatic electronic parts mounting apparatus**

(30) Priority: 25.09.2000 JP 2000290378
(71) Applicant: MATSUSHITA ELECTRIC INDUSTRIAL CO., LTD., Kadoma-shi, Osaka 571-8501 (JP)
(72) Inventor: Kyoutani, Takayoshi, Hirakata-shi, Osaka 573-1107 (JP)
(74) Representative: Leson, Thomas Johannes Alois, Dipl.-Ing.

(57) **Abstract**

A high-speed automatic parts mounting apparatus is provided which is designed to move pick-up nozzles vertically to mount electronic parts on a printed circuit board in sequence. The parts mounting apparatus reads data on height of each of the electronic parts out of a memory to determine a target level of the printed circuit when the electronic parts are mounted on the printed circuit board and moves an X-Y table on which the printed circuit board is held vertically to the target level. Specifically, the level of the printed circuit board is adjusted based on the height of the electronic parts without changing a vertical stroke of the vacuum nozzles. This minimizes the vibration of the vacuum nozzles, thus avoiding a shift in orientation or mounted position of the electronic parts.

## Description

### BACKGROUND OF THE INVENTION

### 1 Technical Field of the Invention

The present invention relates generally to an automatic electronic parts mounting apparatus, and more particularly to a compact and high-speed electronic parts mounting apparatus designed to mount chip components on a printed circuit board, for example, with high accuracy.

### 2 Background Art

Typical electronic parts mounting apparatuses consist essentially of a parts feeder, a circuit board holder, parts-mounting nozzles, and a controller controlling operations of the circuit board holder and the parts-mounting nozzles and realize a high-speed mounting operation, however, have the following drawback.

The parts mounting apparatus are required to mount parts having different heights on a circuit board and thus designed to change the bottom dead center of each of the parts-mounting nozzles as a function of the height of parts to be mounted on the circuit board for avoiding the application of excessive pressure to the parts. The parts mounting apparatuses, therefore, need to have a nozzle-elevating mechanism which is complex in structure and heavy in weight, thus causing great vibrations to be produced in the nozzle-elevating mechanism and transmitted to the nozzles. The vibrations of the nozzles will result in a shift in orientation of the electronic parts or location on the printed circuit board where the parts are to be mounted. Further, when the vibrations are oriented vertically, it may cause damage to the parts.

The above problem has become significant with speeding up of an operation of the parts mounting apparatuses.

### SUMMARY OF THE INVENTION

It is therefore a principal object of the invention to avoid the disadvantages of the prior art.

It is another object of the invention to provide a parts mounting apparatus designed to provides for a high accuracy parts-mounting operation.

According to one aspect of the invention, there is provided a parts mounting apparatus. The parts mounting apparatus comprises: (a) a parts feeder feeding parts; (b) a board holding mechanism including a board holder which holds a board on which the parts are to be mounted at a parts mounting station, the board holder being designed to be moved vertically to hold the board at a given level; (c) a parts mounting mechanism including a mounting unit, the mounting unit working to pick up one of the parts supplied from the parts feeder and move vertically along a vertical constant stoke to mount the picked up part on the board held by the board holder of the board holding mechanism; (d) a storage storing therein parts data on height of each of the parts; and (e) a controller determining a target level at which the board is to be held by the board holder of the board holding mechanism at the parts mounting station based on the parts data on the height of the part held by the mounting unit of the parts mounting mechanism and controlling an operation of the board holding mechanism to move the board holder vertically so that the board holder holds the board at the target level for mounting the part on the board at the parts mounting station.

In the preferred mode of the invention, the board holder is moved vertically by an electronic motor through a mechanism linkage.

The mechanical linkage is implemented by a lever linkage connecting at one end with an output shaft of the electronic motor and at the other end with the board holder.

The board holder includes an upper and a lower rail and a first urging member. One of the upper and lower rails has a vertically elongated hole into which a pin is inserted through the other of the upper and lower rails. The first urging member is disposed between the upper and lower rails to urge the upper and lower rails vertically in opposite directions. The board holding mechanism has a supporting member carried on a second urging member below the lower rail. The controller moves the upper rail downward along with the lower rail with aid of urging pressure of the first urging member until the lower rail hits on the supporting member, lowers the upper rail further relative to the lower rail to nip the board between the upper rail and the lower rail, and lowers the upper rail further along with the lower rail against urging pressure of the second urging member to bring the board to the target level.

When it is required to mount parts of different height, the controller controls the mounting unit so as to mount the parts in order of having shorter height.

### BRIEF DESPCRIPTION OF THE DRAWINGS

The present invention will be understood more fully from the detailed description given hereinbelow and from the accompanying drawings of the preferred embodiments of the invention, which, however, should not be taken to limit the invention to the specific embodiments but are for the purpose of explanation and understanding only.

### In the drawings:

Fig. 1 is a plan view which shows a parts mounting apparatus according to the present invention;
Fig. 2 is a perspective view which shows a parts mounting head of the parts mounting apparatus of Fig. 1;
Fig. 3 is a perspective view which shows a board holding unit which holds a printed circuit board on which electronic parts are to be mounted;
Fig. 4 is a bock diagram which shows a control system of the parts mounting apparatus of Fig. 1;
Fig. 5 is a side view which shows the board holding unit of Fig. 3;
Fig. 6 is a partially sectional view which shows a rail unit of the board holding unit of Fig. 5;
Fig. 7 is a partially sectional view which shows an internal structure of the rail unit of Fig. 6;
Fig. 8 is a side which shows a board holding unit when bringing a printed circuit board to a given level after the printed circuit board is loaded onto the board holding unit;
Fig. 9 is a partially sectional view which shows a rail unit of the board holding unit of Fig. 8;
Fig. 10 is a partially sectional view which shows an internal structure of the rail unit of Fig. 8; and
Figs. 11(a), 11(b), and 11(c) show levels of a printed circuit board held by a board holding unit in a case where electronic parts of different heights are mounted on the printed circuit board.

### DESCRIPTION OF THE PREFERRED EMBODIMENTS

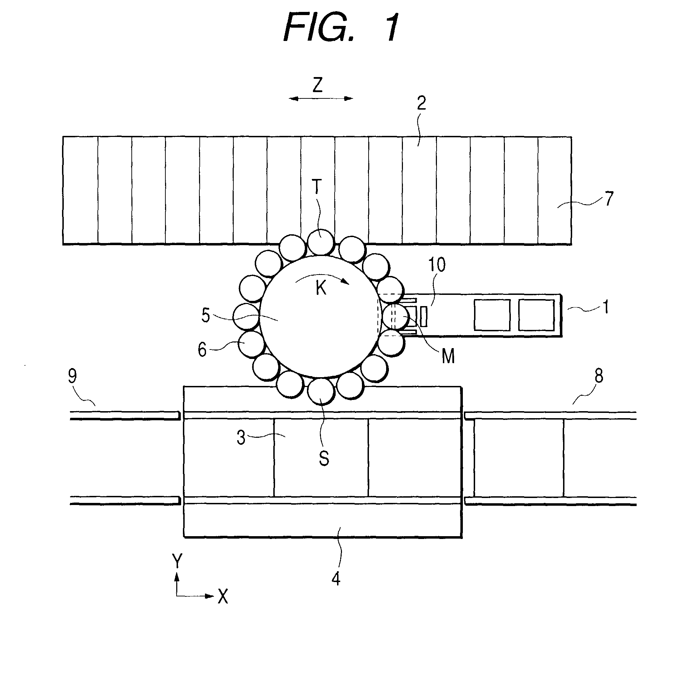

Referring to the drawings, wherein like reference numbers refer to like parts in several views, particularly to Fig. 1, there is shown a parts mounting apparatus 1 according to the present invention.

The parts mounting apparatus 1 includes generally a parts-feeding mechanism 2 and a board holding mechanism 4. The parts-feeding mechanism 2 is constructed to move in a *Z*-direction. The board holding mechanism 4 holds thereon a printed circuit board 3 and is designed to move in *X*- and *Y*-directions.

Disposed between the parts-feeding mechanism 2 and the board holding mechanism 4 is a rotary head table 5 which turns intermittently in a *K*-direction. The rotary head table 5 has sixteen mounting heads 6 installed therearound at regular intervals.

The parts-feeding mechanism 2 consists of a plurality of parts-feeding units 7 arranged adjacent to each other in the *Z*-direction. The parts-feeding units 7 work to supply electronic parts different from each other to a pick-up station *T*.

The parts mounting apparatus 1 also includes a parts monitor 10, a board loader 8 and a board unloader 9 arranged in alignment with each other across the board holding mechanism 4. The board loader 8 transports the printed circuit board 3 to the board holding mechanism 4 upon initiation of a parts-mounting operation to mount the electronic parts on the printed circuit board 3 at a mounting station *S.* After completion of the parts-mounting operation, the printed circuit board 3 is carried to the board unloader 9. The parts monitor 10 works to monitor the presence or absence of an electronic part transported from the pick-up station *T* to the mounting station *S* and the orientation thereof at a check station *M*.

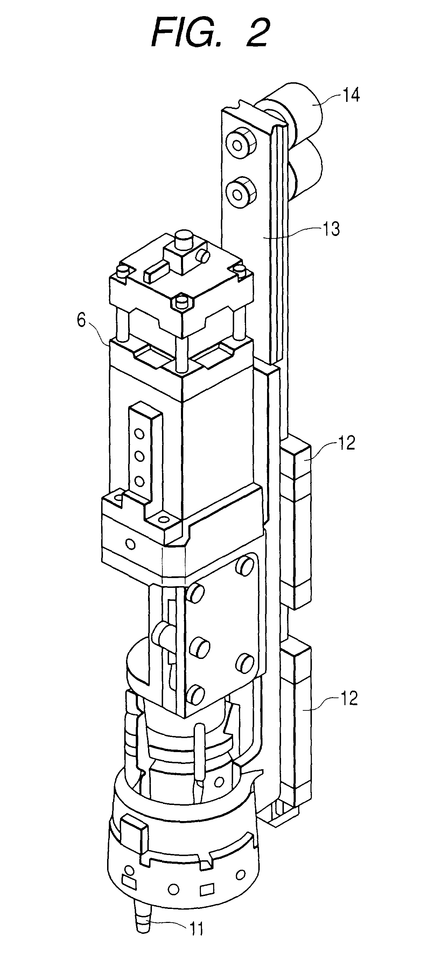

Each of the mounting heads 6, as shown in Fig. 2, has a pick-up nozzle 11 (e.g., vacuum nozzles) which picks up one electronic part at the pick-up station *T* and transports it to the mounting station S. The mounting head 6 is retained by a rail 13. The rail 13 has installed on an upper end thereof rollers 14 which are mechanically connected to a drive mechanism (not shown). The rail 13 is moved by the rollers 14 vertically through linear guides 12 to lift the pick-up nozzle 11 up and down. The linear guides 12 are attached to the periphery of the rotary head table 5. The pick-up nozzle 11 is elevated up and down in a range defined by fixed upper and lower dead centers. Specifically, a vertical stroke of the pick-up nozzle 11 is maintained constant regardless of the size of the electronic parts to be mounted on the printed circuit board 3.

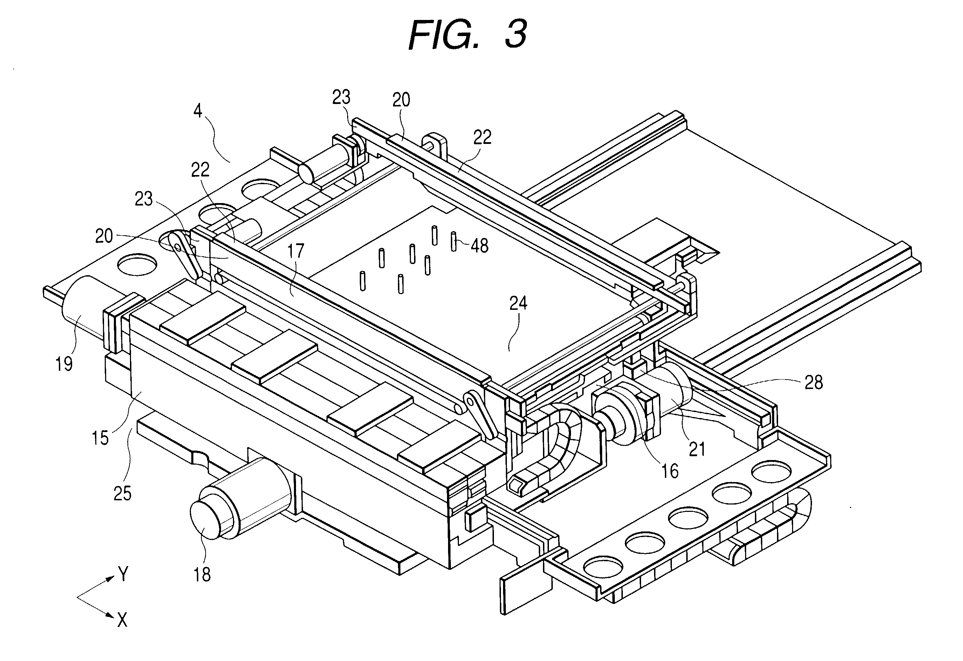

The board holding mechanism 4, as clearly shown in Fig. 3, includes an *X-Y* table assembly 25 and a board holding unit 17. The *X-Y* table assembly 25 consists of a *Y-*table 15 and an *X*-table 16 disposed on the *Y*-table 15. The board holding unit 17 is secured on the *X*-table 16. The *Y*-table 16 is moved in the *Y*-direction by a *Y*-axis electric motor 18 through a ball screw (not shown). Similarly, the *Y*-table 15 is moved in the *X*-direction by an *X*-axis electric motor 19 through a ball screw (not shown).

The board holding unit 17 includes a pair of rail units 20 extending in parallel in the *X*-direction. Each of the rail unit 20 consists of an upper rail 22 and a lower rail 23. The upper and lower rails 22 and 23 are each made of a strip member of L-shape in cross section. The rail units 20 hold a front edge portion and a rear edge portion of the printed circuit board 3, respectively, and are moved vertically, as will be described later in detail, by a lift electric motor 21.

Disposed beneath the rail units 20 is a support plate 24 on which the lower rail 23 is rested when moved downward.

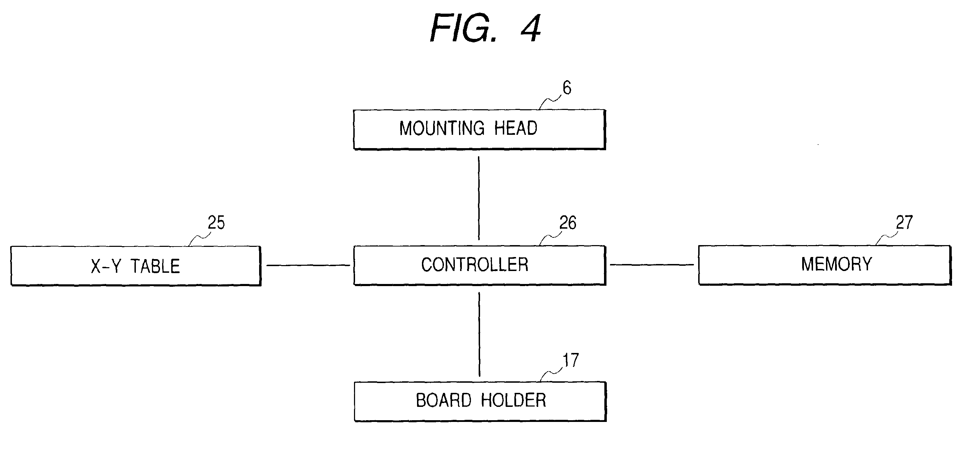

The vertical movement of the board holding unit 17 is controlled, as shown in Fig. 4, by a controller 26. The controller 26 also works to control operations of the mounting heads 6 and the *X-Y* table assembly 25 and is connected electrically to a memory 27. The memory 27 stores therein parts data on the order in which electronic parts are to be mounted on the printed circuit board 3, dimensions such as the heights of the electronic parts, and mounting location of the electronic parts to be mounted on the printed circuit board 3. Upon initiation of the parts-mounting operation of the parts mounting apparatus 1, the controller 26 reads the parts data out of the memory 27 to control the operations of the mounting heads 6, the *X*-*Y* table assembly 25, and the board holding unit 17. Specifically, the controller 26 analyzes the parts data on the height of the electronic parts to determine a target parts-mounting level at which the electronic parts are mounted on the printed circuit board 3 and moves the board holding unit 17 vertically to bring the printed circuit board 3 to the target parts-mounting level. The controller 26 also analyzes the mounting locations of the electronic parts and moves the *X*-table 16 and the *Y*-table 15 of the *X-Y* table assembly 25.

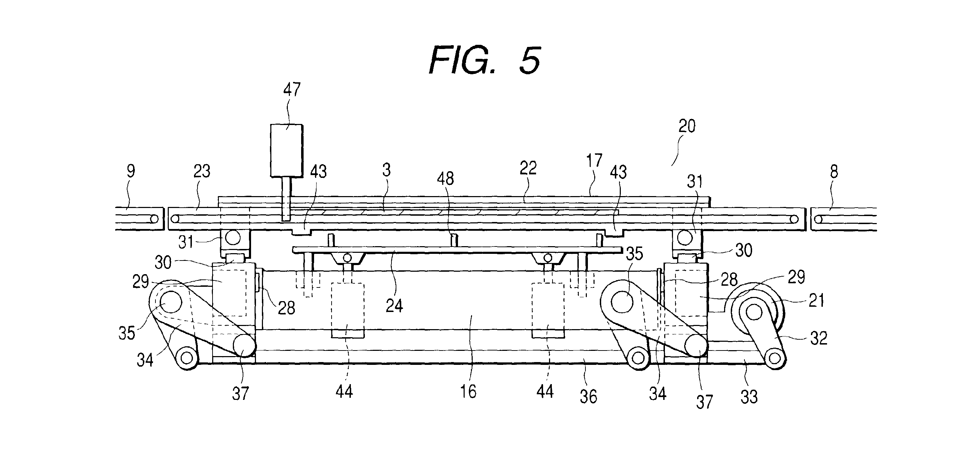

The lift motor 21 is, as clearly shown in Figs. 3 and 5, mounted on a right side surface of the *X*-table 16, as viewed in the drawings. Fig. 5 and Figs. 6 and 7, as referred to later, illustrate for a case where the board holding unit 17 is lifted up to the same level as those of the board loader 8 and the board unloader 9 when the printed circuit board 3 is supplied to or transported out of the board holding mechanism 4. The lift motor 21 has an output shaft coupled to an end of a lever 32. The lever 32 is coupled at the other end with an end of a connecting rod 33 rotatably. The connecting rod 33 is coupled at the other end with an end of a V-shaped lever 34 installed on the right side portion of the *X*-table 16 rotatably.

A V-shaped lever 34 identical with the right side lever 34 is installed on the left side portion of the *X*-table 16. The two levers 34 is retained by pivots 35 installed on the *X*-table 16 and are coupled at ends thereof to each other through a connecting rod 36 so that the levers 34 may swing about the pivots 35 synchronously.
Connected to the other ends of the levers 34 are cam followers 37 which engage grooves formed in right and left blocks 29, respectively.

The right and left blocks 29 are so mounted on side walls of the *X*-table 16 as to be slidable vertically through linear guides 28. The two linear guides 28 are mounted on front and rear side walls of each of the blocks 29.

A block 31 is disposed on an upper surface of each of the blocks 29 through a linear guide 30. The blocks 31 connect at upper ends thereof to the upper rails 22 of the rail units 20 of the board holding unit 17.

When the controller 26 actuates the lift motor 21, it will cause the lever 32 to swing. The swing of the lever 32 causes the connecting rods 33 and 36 to move horizontally, as viewed in Fig. 5 to swing the levers 34 about the pivots 35, thereby moving the blocks 29 vertically through the cam followers 37 so that the upper rails 22 are lifted up or down along the linear guides 30 and the blocks 31. Specifically, the levers 32 and 34, the connecting rods 33 and 36, the blocks 29 and 31 connect the output shaft of the lift motor 21 and the upper rails 22 of the board holding unit 17 to convert rotation of the lift motor 21 into a vertical movement of the upper rails 22.

Each of the rail units 20, as shown in Figs. 3 and 5 to 7, consists of the upper lower rails 22 and 23 extending in the *X*-direction. The lower rail 23 is of L-shaped in cross section and has formed therein holes 38 elongated vertically. A pin 38 is inserted into each of the holes 38 through the upper rail 22 so that the upper rail 22 may be moved vertically relative to the lower rail 23 within a range defined by the length of the hole 38. Springs 40 are disposed between the upper and lower rails 22 and 23 to urge the upper and lower rails 22 and 23 vertically in opposite directions at all times.

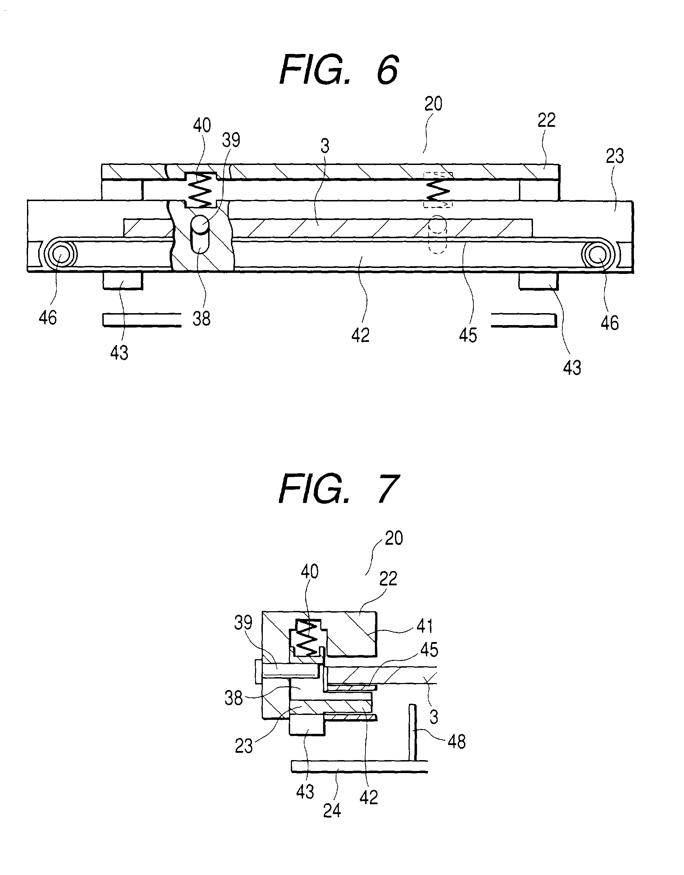

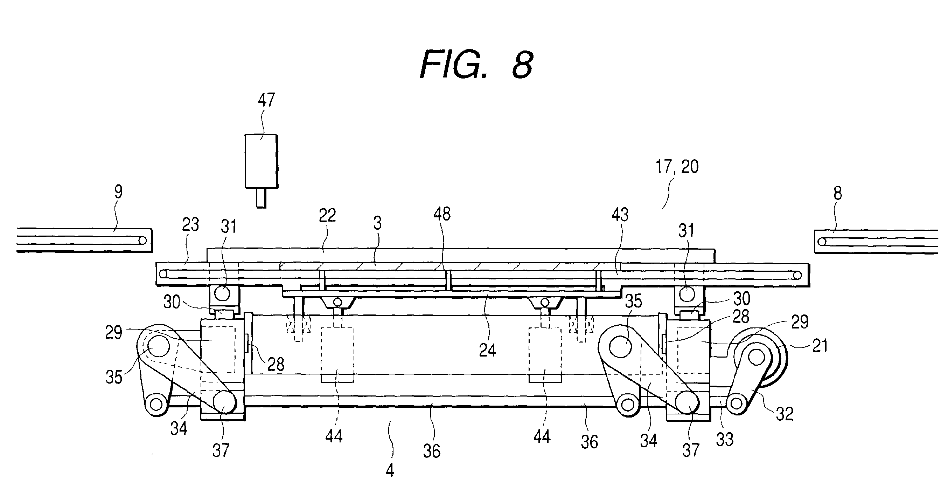

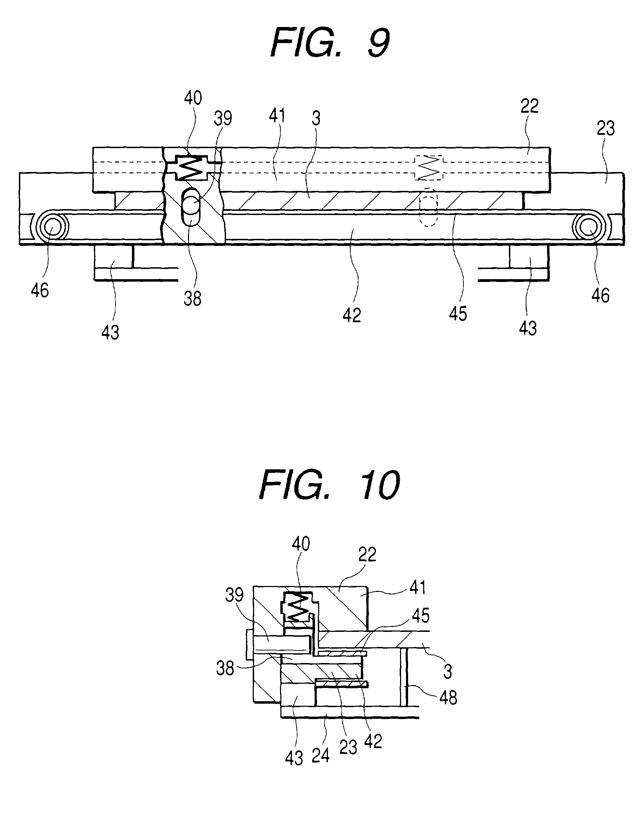

The upper and lower rails 23 and 23 have board grips 41 and 42 formed on inner ends thereof (i.e., the right side as viewed in Fig. 7). When the printed circuit board 3 starts to be loaded onto the *X-Y* table assembly 25, the board grips 41 and 42 are placed to form a gap through which the printed circuit board 3 is transported by endless belts 45, as clearly shown in Figs. 9 and 10. Each of the belts 45 is carried by a pair of pulleys 46 and extends beneath the grips 41 and 42 of the upper and lower rails 22 and 23. When it is required to hold the printed circuit board 3 on the *X-Y* table assembly 25, the upper rails 22 are moved, as shown in Figs. 8 to 10, toward the lower rails 23 against the spring pressure of the springs 40 to nip the edge of the printed circuit board 3.

The transportation of the printed circuit board 3 is initiated when the board holding unit 17 is, as shown in Figs. 5 to 7, lifted up to the same level as those of the board loader 8 and the board unloader 9 by the lift motor 21 through the lever linkage as described above. The printed circuit board 3 is supplied from the board loader 8 to the board holding unit 17. A stopper cylinder 47 is moved downward, as shown in Fig. 5, to arrest the advancing movement of the printed circuit board 3. After completion of the parts-mounting operation, the stopper cylinder 47 is elevated to allow the printed circuit board 3 to advance toward the board unloader 9.

Each of the lower rails 23, as clearly shown in Figs. 5 to 10, has protrusions 43 formed on the bottom surface thereof. The protrusions 43 each have a flat bottom surface. The support plate 24 is, as described above, disposed beneath the lower rails 23 and carried on air cylinders 44 at a constant level above the *X*-table 16. The support plate 24 has installed thereon a plurality of backup pins 48 serving to carry a central portion of the printed circuit board 3 horizontally.

In operation, when it is required to initiate the parts-mounting operation, the controller 26 reads the above described parts data out of the memory 27 and turns on the lift motor 2 to elevate, as shown in Figs. 5 to 7, the board holding unit 17 until the rail units 20 reach a board-transporting level (i.e., the level of the loader 8 and the unloader 9). Next, the printed circuit board 3 is transported from the loader 8 to the lower rails 23 of the rail units 20 through the belts 45 and stopped by the stopper cylinder 47.

The controller 26 turns the lift motor 21 in a reverse direction to move the upper rails 22 of the rail units 20 downward through the lever linkage, as described above. Upon the downward movement of the upper rails 22, the lower rails 23 is moved downward by the spring pressure of the springs 40 until the protrusions 43 hit on the upper surface of the support plate 24. The pressure produced by the air cylinders 44 carrying the support plate 24 is set greater than a total of the spring pressures of the springs 40 disposed between the upper and lower rails 22 and 23. Thus, after the protrusions 43 of the lower rails 23 hit on the support plate 24, the lower rails 23 are kept at a given level, while the upper rails 22, as shown in Figs. 9 and 10, continue to move downward against the spring pressure of the springs 40 and then nip the edge of the printed circuit board 3 between the grips 41 and 42 of the upper and lower rails 22 and 23. The level at which the printed circuit board 3 is nipped by the grips 41 and 42 will be referred to as a board-holding level below.

Subsequently, the controller 26 analyzes the parts data on the height of the electronic parts to be mounted on the printed circuit board 3 and determines a target level of the printed circuit board 3. The controller 26 lowers the upper rails 22 further through the lift motor 21 to move the rail units 20 (i.e., the board holding unit 17) downward below the board-holding level against the air pressure of the air cylinders 44 until the printed circuit board 3 reaches the target level.

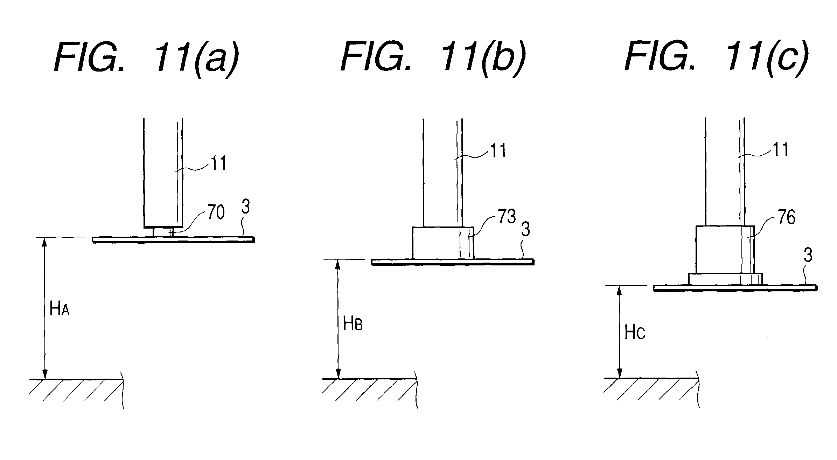

The controller 26 analyzes the parts data to determine a mounting location of a portion of the printed circuit board 3 where a first one of the electronic parts is to be mounted and moves the *X*-table 16 and the *Y*-table 15 to bring the mounting location of the printed circuit board 3 to the mounting station *S*, as shown in Fig. 1. Next, the controller 26 lowers the mounting head 6 (i.e., the pickup nozzle 11) along a constant vertical stroke and mounts the electronic part held by the pick-up nozzle 11 on the printed circuit board 3. The controller 26 repeats this operation until it finishes mounting all electronic parts on the printed circuit board 3. It is advisable that the controller 26 mount the electronic parts in the order of having a smaller height, thereby allowing the controller 26 to complete the parts-mounting operation only by moving the board holding unit 17 downward. For example, when it is required to mount electronic parts 70, 73, and 76 of different heights, as shown in Figs. 11(a), 11(b), and 11(c), on the printed circuit board 3, the controller 26 first holds, as shown in Fig. 11(a), the printed circuit board 3 at the highest level *H*_{*A*} from a stationary base (e.g., the *X*-table 16) of the board holding mechanism 4 and mounts the shortest part 70 on the printed circuit board 3. Next, the controller 26 moves the printed circuit board 3 downward to the level *H*_{*B*}, as shown in Fig. 11(b), and then mounts the medium height part 73 on the printed circuit board 3. Finally, the controller 26 lowers the printed circuit board 3 further to the level *H*_{*C*}, as shown in Fig. 11(c), and then mounts the tallest part 76 on the printed circuit board 3. This minimizes a total length of a vertical stroke of the board holding unit 17, thus avoiding the application of an excessive load on the electronic parts and also avoids the interference of a shorter part with a taller part being mounted on the printed circuit board 3. As can be seen from Figs. 11(a) to 11(c), the vertical stroke of the pick-up nozzle 11 of each of the mounting heads 6 when the electronic parts are mounted on the printed circuit board 3 is constant during the parts-mounting operation, thereby minimizing the vibration of the nozzle 11, avoiding a shift in mounted position of the electronic parts.

The vertical movement of the board holding unit 17 is, as apparent form the above discussion, accomplished only by the lever linkage and the lift motor 21, thereby allowing the level of the printed circuit board 3 to be brought into agreement with a target one accurately at high speed and providing for a smooth movement of the printed circuit board 3, thus resulting in a decrease in vibration of the whole of the parts mounting apparatus 1. The board holding unit 17 has a simple structure, thus allowing the weight of the parts mounting apparatus 1 to be decreased as a whole.

While the present invention has been disclosed in terms of the preferred embodiments in order to facilitate better understanding thereof, it should be appreciated that the invention can be embodied in various ways without departing from the principle of the invention. Therefore, the invention should be understood to include all possible embodiments and modifications to the shown embodiments witch can be embodied without departing from the principle of the invention as set forth in the appended claims.

A high-speed automatic parts mounting apparatus is provided which is designed to move pick-up nozzles vertically to mount electronic parts on a printed circuit board in sequence. The parts mounting apparatus reads data on height of each of the electronic parts out of a memory to determine a target level of the printed circuit when the electronic parts are mounted on the printed circuit board and moves an *X-Y* table on which the printed circuit board is held vertically to the target level. Specifically, the level of the printed circuit board is adjusted based on the height of the electronic parts without changing a vertical stroke of the vacuum nozzles. This minimizes the vibration of the vacuum nozzles, thus avoiding a shift in orientation or mounted position of the electronic parts.

## Claims

1. A parts mounting apparatus comprising:
a parts feeder feeding parts;
a board holding mechanism including a board holder which holds a board on which the parts are to be mounted at a parts mounting station, said board holder being designed to be moved vertically to hold the board at a given level;
a parts mounting mechanism including a mounting unit, the mounting unit working to pick up one of the parts supplied from said parts feeder and move vertically along a vertical constant stoke to mount the picked up part on the board held by the board holder of said board holding mechanism;
a storage storing therein parts data on height of each of the parts; and
a controller determining a target level at which the board is to be held by the board holder of said board holding mechanism at the parts mounting station based on the parts data on the height of the part held by the mounting unit of said parts mounting mechanism and controlling an operation of said board holding mechanism to move the board holder vertically so that the board holder holds the board at the target level for mounting the part on the board at the parts mounting station.

2. A parts mounting apparatus as set forth in claim 1, wherein said board holder is moved vertically by an electronic motor through a mechanism linkage.

3. A parts mounting apparatus as set forth in claim 2, wherein the mechanical linkage is implemented by a lever linkage connecting at one end with an output shaft of the electronic motor and at the other end with said board holder.

4. A parts mounting apparatus as set forth in claim 1, wherein said board holder includes an upper and a lower rail and a first urging member, one of the upper and lower rails having a vertically elongated hole into which a pin is inserted through the other of the upper and lower rails, the first urging member being disposed between the upper and lower rails to urge the upper and lower rails vertically in opposite directions, wherein said board holding mechanism has a supporting member carried on a second urging member below the lower rail, and wherein said controller moves the upper rail downward along with the lower rail with aid of urging pressure of the first urging member until the lower rail hits on the supporting member, lowers the upper rail further relative to the lower rail to nip the board between the upper rail and the lower rail, and lowers the upper rail further along with the lower rail against urging pressure of the second urging member to bring the board to the target level.

5. A parts mounting apparatus as set forth in claim 1, wherein when it is required to mount parts of different height, the controller controls said mounting unit so as to mount the parts in order of having shorter height.
